Europäisches Patentamt

European Patent Office

Office européen des brevets

(11) Numéro de publication: **0 298 569 B1**

(12) **FASCICULE DE BREVET EUROPEEN**

(45) Date de publication de fascicule du brevet: **11.11.92**

(51) Int. Cl.⁵: **G01S  15/52**, H03H 15/00, H03H 17/06

(21) Numéro de dépôt: **88201427.7**

(22) Date de dépôt: **07.07.88**

(54) Dispositif d'élimination d'échos fixes pour échographe ultrasonore.

(30) Priorité: **09.07.87 FR 8709734**

(43) Date de publication de la demande:
**11.01.89 Bulletin  89/02**

(45) Mention de la délivrance du brevet:
**11.11.92 Bulletin  92/46**

(84) Etats contractants désignés:
**BE DE FR GB**

(56) Documents cités:
**DE-A- 3 214 938**     **GB-A- 2 104 332**
**US-A- 2 842 761**     **US-A- 3 521 041**
**US-A- 4 318 099**     **US-A- 4 324 258**
**US-A- 4 340 875**

(73) Titulaire: **LABORATOIRES D'ELECTRONIOUE PHILIPS**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**BE DE GB**

(72) Inventeur: **Pesque, Patrick**
**SOCIETE CIVILE S.P.I.D. 209, rue de l'Université**
**F-75007 Paris(FR)**
Inventeur: **Bonnefous, Odile**
**SOCIETE CIVILE S.P.I.D. 209, rue de l'Université**
**F-75007 Paris(FR)**

(74) Mandataire: **Charpail, François et al**
**Société Civile S.P.I.D. 156, Boulevard Haussmann**
**F-75008 Paris(FR)**

Rank Xerox (UK) Business Services

EP 0 298 569 B1

## Description

La présente invention concerne un dispositif d'élimination d'échos fixes pour échographe ultrasonore, comportant un filtre du type à lignes à retard.

Le dispositif d'élimination d'échos fixes selon l'invention trouve une application particulièrement avantageuse dans la mesure et l'imagerie des vitesses d'écoulements sanguins par échographie ultrasonore.

Le problème technique général à résoudre par tout échographe ultrasonore destiné à la mesure et à l'imagerie des vitesses d'écoulements sanguins est d'éliminer les échos fixes dus à la grande réflectivité des tissus biologiques (ici, les parois des vaisseaux) qui peut dépasser de 40 dB la réflectivité du sang (globules rouges). L'utilisation d'un dispositif d'élimination d'échos fixes est donc indispensable, avant toute estimation du profil de vitesse, pour réduire la dynamique des signaux à traiter et pour mesurer correctement les vitesses d'écoulement sur toute une section des vaisseaux, en particulier les faibles vitesses qui apparaissent au voisinage des parois de vaisseaux et qui sont, de ce fait, masquées par les forts signaux provenant de ces parois.

Une solution à ce problème technique général est donnée, par exemple, dans la demande de brevet français n° 2 580 076 qui décrit un dispositif d'élimination d'échos fixes pour échographe ultrasonore, comportant un filtre, du type à lignes à retard, composé en l'espèce d'une ligne retardée d'une période de récurrence en parallèle sur une ligne de retard nul. Des coefficients de pondération, respectivement ±1, sont affectés à ces lignes qui, après pondération, sont additionnées par un additionneur. Ce filtre connu réalise donc la différence entre deux lignes échographiques consécutives ce qui, par principe, conduit à une diminution quasi complète des échos produits par les tissus fixes. Toutefois, cette technique présente l'inconvénient majeur d'atténuer également les signaux correspondant aux faibles vitesses d'écoulement. A titre d'exemple, on peut montrer que la réponse du filtre ci-dessus en fonction de la vitesse d'écoulement est telle que, pour une fréquence de récurrence de 5kHz et une fréquence d'émission de 5MHz, un signal correspondant à v = 5cm/s est atténué de 30dB.

Ceci rend difficile, voire impossible, la mesure des vitesses d'écoulement là où elles sont les plus faibles, c'est à dire près des parois des vaisseaux. Or, la connaissance de ces vitesses est très importante pour l'étude et le diagnostic clinique des artères, par exemple.

Le problème à résoudre par la présente invention est de proposer un dispositif d'élimination d'échos fixes pour échographe ultrasonore, dispositif grâce auquel on puisse obtenir une estimation satisfaisante des faibles vitesses d'écoulements sanguins, notamment à proximité des parois des vaisseaux.

La solution au problème technique posé consiste, selon la présente invention, en ce que le dispositif comporte un premier filtre composé, d'une part, de M lignes parallèles i (i = 1,...,M) de retard respectif (i-1)T, T étant la période de récurrence de l'échographe, d'autre part, de moyens de pondération des M lignes i, la somme des coefficients affectés auxdites lignes étant nulle, et, enfin, d'un additionneur des lignes i ainsi retardées et pondérées, audit premier filtre, étant associé en parallèle au moins un deuxième filtre de même structure, conjugué du premier filtre et déphasé de (M-1)T, la réponse impulsionnelle $h_2(t)$ du deuxième filtre étant reliée à la réponse impulsionnelle $h_1(t)$ du premier filtre par :

$$h_2(t) = h_1((M-1)T-t) \qquad (1).$$

Il est connu que l'on peut augmenter la pente d'un filtre dans la zone de coupure en augmentant son ordre. Appliqué à la mesure des vitesses par échographie, ceci revient à traiter non plus 2 lignes échographiques successives mais d'avantage, soit M, à l'aide d'un filtre du type à lignes à retard, composé de M lignes parallèles i de retard respectif (i-1)T. De façon à assurer l'élimination des échos fixes, les M lignes sont pondérées par des coefficients dont la somme est nulle. Puis toutes les lignes sont additionnées pour ensuite être traitées par un circuit estimateur de vitesse, par corrélation, décalage de phase, etc... Cependant, il est difficile avec ce type de filtre d'obtenir à la fois une bonne mesure du profil de vitesse de l'écoulement étudié et une cadence d'image élevée. Si N est le nombre de lignes à traiter (typiquement N = 16 pour les vaisseaux périphériques et N = 8 pour le coeur), et si M lignes sont utilisées pour le filtre d'élimination des échos fixes, il ne reste en réalité que N-M + 1 lignes utilisables pour l'estimation de vitesse, ou alors, pour avoir le même nombre de lignes à traiter, il faudrait diminuer la cadence d'image.

Le dispositif selon l'invention comporte deux filtres d'ordre M-1 ayant, en module, la même réponse en fréquence, condition essentielle pour que ces deux filtres puissent être associés. En effet, de l'équation (1) on tire la relation entre les réponses en fréquence $H_1(f)$ et $H_2(f)$ :

$$H_2(f) = \overline{H_1}(f) \exp(j2\pi f(M-1)T)$$
$$\text{d'où } |H_2(f)| = |H_1(f)|$$

D'autre part, on dispose de 2(N-M + 1) signaux pour estimer les vitesses au lieu de N-M + 1. Ces signaux ne sont pas tout à fait indépendants, mais avec un estimateur de vitesse utilisant une opération non linéaire (corrélation 1 bit, décalage de phase,...), le gain est néanmoins appréciable. On obtient alors, sans diminution importante des lignes à traiter, donc sans réduction de la cadence d'image, une estimation satisfaisante des faibles vitesses d'écoulements sanguins.

La description qui va suivre, en regard des dessins annexés donnés à titre d'exemples non limitatifs, fera bien comprendre en quoi consiste l'invention et comment elle peut être réalisée.

La figure 1 est le schéma d'un dispositif d'élimination d'échos fixes selon l'invention.

La figure 2 est le diagramme de la réponse en vitesse d'un dispositif d'élimination d'échos fixes à trois points.

La figure 3 est un schéma montrant comment le dispositif d'élimination d'échos fixes peut être associé à un estimateur de vitesse.

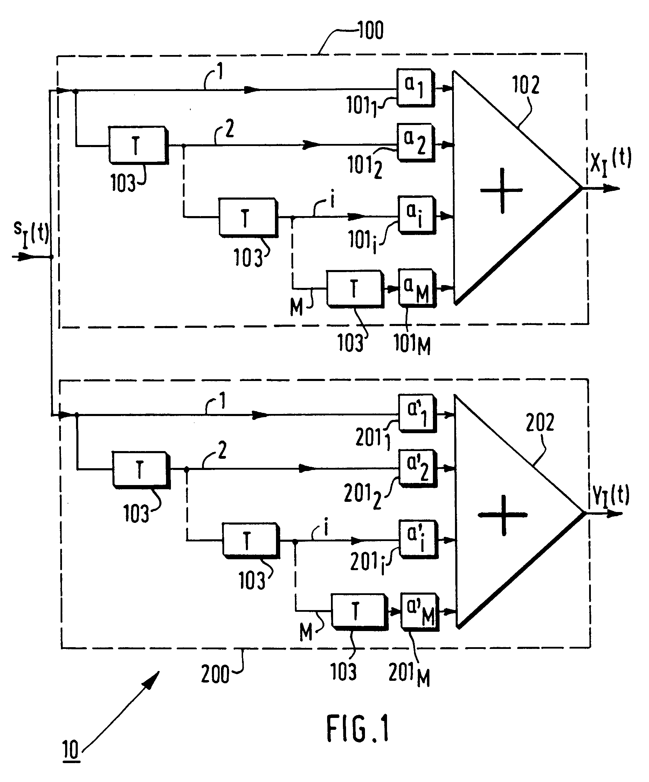

La figure 1 donne le schéma d'un dispositif 10 d'élimination d'échos fixes pour échographe ultrasonore. Ce dispositif se trouve placé, d'une façon générale, entre le circuit de réception du faisceau ultrasonore et l'estimateur de vitesse. Comme le montre la figure 1, le dispositif 10 d'élimination d'échos fixes représenté comporte un premier filtre 100 composé, d'une part, de M lignes $i (i = 1,...,M)$ de retard respectif $(i-1)T$, T étant la période de récurrence de l'échographe. Ces retards sont obtenus à l'aide des lignes à retard 103. D'autre part, le filtre 100 comprend également des moyens de pondération $101_1,...101_M$ des M lignes i. De façon à assurer l'élimination des échos fixes, la somme des coefficients $a_1,...a_M$ affectés auxdites lignes par les moyens de pondération $101_1,...,101_M$ est nulle :

$$\sum_{i=1}^{M} a_i = 0$$

Enfin, un additionneur 102 fait la somme des lignes i ainsi retardées et pondérées.

La réponse impulsionnelle $h_1(t)$ du filtre 100 est égale à :

$$h_1(t) = \sum_{i=1}^{M} a_i \delta (t-(i-1)T)$$

où $\delta(t)$ est la fonction de Dirac.

La réponse du filtre 100 à un signal échographique $s_I(t)$ provenant du circuit de réception de l'échographe, I étant le rang du tir correspondant, est donc donnée par :

$$X_I(t) = \sum_{i=1}^{M} a_i s_{I-(i-1)}(t)$$

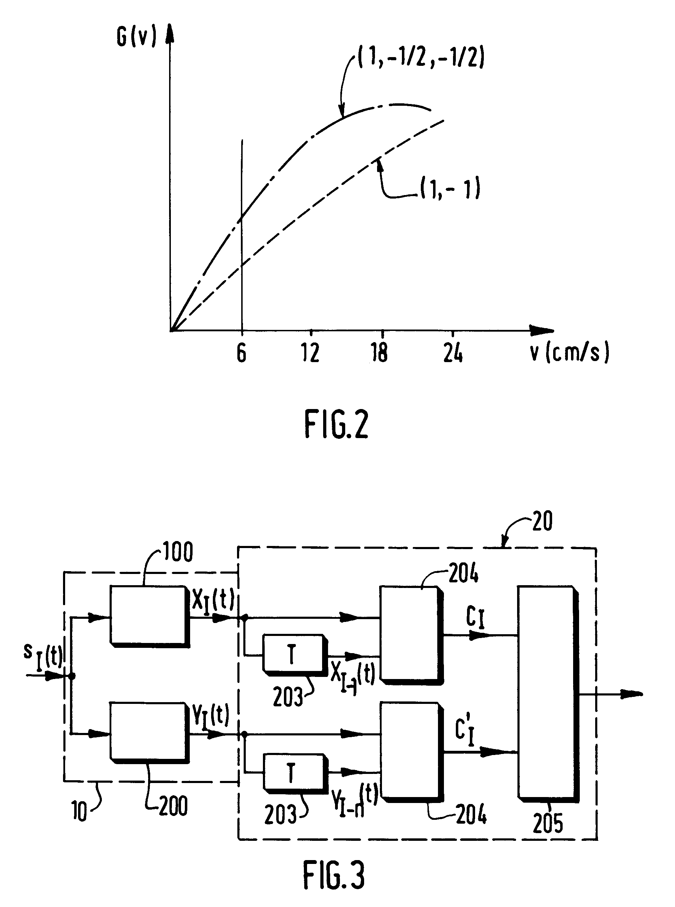

La réponse en vitesse G(v) d'un filtre 100 pour lequel M vaut 3 et les coefficients $a_1$, $a_2$ et $a_3$ respectivement 1, -1/2, -1/2, est montrée à la figure 2. On voit que ce filtre a une sensibilité aux faibles vitesses beaucoup plus grande que le filtre d'ordre 1 correspondant pour lequel $a_1 = 1$ et $a_2 = -1$. En particulier, pour une vitesse de 6cm/s, le gain en réponse est de 6dB.

Par contre, on voit que sur N lignes successives à traiter $(I = 1,...,N)$, M sont utilisées pour l'élimination des échos fixes et que par conséquent seules N-M + 1 serviront effectivement à estimer la vitesse. D'où une précision de mesure moins grande ou l'obligation de diminuer la cadence d'image.

Comme on peut le voir à la figure 1, le dispositif 10 d'élimination d'échos fixes comporte également, en parallèle avec le filtre 100, appelé premier filtre, un deuxième filtre 200 qui présente la même structure que ledit premier filtre 100. Le deuxième filtre 200 est conjugué du premier filtre 100 et déphasé de (M-1)T, sa réponse impulsionnelle $h_2(t)$ étant reliée à $h_1(t)$ par :

$$h_2(t) = h_1((M-1)T-t) \qquad (2)$$

Comme, par ailleurs, $h_2(t)$ est aussi donné par

$$h_2(t) = \sum_{i=1}^{M} a'_i \delta(t-(i-1)T)$$

où les coefficients $a'_i$ sont ceux fournis par les moyens de pondération $201_i$, on voit qu'il existe nécessairement une relation entre les coefficients $a_i$ et $a'_i$. Par exemple, si M est égal à 3, on a :

$$h_1(t) = a_1\delta(t) + a_2\delta(t-T) + a_3\delta(t-2T)$$
$$h_2(t) = a'_1\delta(t) + a'_2\delta(t-T) + a'_3\delta(t-2T)$$

La relation (2) implique :
$$a'_1 = a_3$$
$$a'_2 = a_2$$
$$a'_3 = a_1$$

En sortie de l'additionneur 202, le signal fourni par le filtre 200 est :

$$Y_I(t) = \sum_{i=1}^{M} a'_i \, s_{I-(i-1)}(t)$$

La réponse en vitesse G(v) du deuxième filtre 200 est la même que celle du premier filtre 100. Avec des coefficients $a'_1$, $a'_2$, $a'_3$ égaux respectivement à -1/2, -1/2, 1, la réponse G(v) du deuxième filtre est donc donnée par la courbe en trait mixte de la figure 2.

Lorsque la relation (2) est satisfaite, et comme on l'a montré plus haut, les deux filtres 100 et 200 ont, en module, la même réponse en fréquence, et donc en énergie.

Le dispositif 10 d'élimination d'échos fixes selon l'invention peut donc être considéré comme un filtre unique ayant pour réponse en vitesse et pour module de réponse en énergie respectivement la résponse en vitesse commune G(v) et le module de résponse en énergie commun aux deux filtres 100 et 200. L'avantage du dispositif 10 d'élimination d'échos fixes montré à la figure 1 est qu'il permet de traiter 2(N-M+1) lignes pour estimer la vitesse au lieu de N-M+1 comme c'est le cas pour chacun des filtres 100 et 200 pris séparément.

Il est bien clair cependant que les signaux $X_I(t)$ et $Y_I(t)$ provenant des filtres 100 et 200 ne sont pas indépendants dans la mesure où ils sont construits à partir des mêmes signaux d'entrée $s_I(t)$. Toutefois, ils sont différents du fait que les coefficients de pondération $a_i$ et $a'_i$ sont différents. Pour tirer parti de cette différence, l'estimateur de vitesses qui traite les signaux $X_I(t)$ et $Y_I(t)$ doit utiliser une opération non linéaire.

La figure 3 montre un exemple de la façon dont un dispositif 10 d'élimination d'échos fixes conforme à l'invention peut être associé à un estimateur 20 de vitesse. Les signaux $X_I(t)$ et $Y_I(t)$ issus respectivement des filtres 100 et 200 sont retardés d'une période de récurrence T par les lignes à retard 203 de sorte que les signaux successifs $X_I(t)$, $X_{T-1}(t)$, d'une part, et $Y_I(t)$, $Y_{I-1}(t)$, d'autre part, puissent être traités par les circuits, identiques, 204. Ces circuits 204 peuvent être des corrélateurs qui permettent d'extraire les fonctions de corrélation $C_I$ et $C'_I$. Un exemple de tels corrélateurs est donné dans la demande de brevet français n° 85 17851 qui montre également comment la mesure des fonctions de corrélation permet de déterminer les vitesses d'écoulement recherchées. Ensuite, ces fonctions de corrélation $C_I$ et $C'_I$ sont non seulement accumulées sur I (I=1,...,N-M+1) mais également entre elles, dans un accumulateur 205, ce qui augmente de façon non négligeable le rapport signal à bruit de l'estimateur de vitesse.

A la place de corrélateurs, on peut également utiliser pour les circuits 204 des déphaseurs, le déphasage entre deux lignes échographiques étant fonction de la vitesse d'écoulement.

## Revendications

1. Dispositif d'élimination d'échos fixes pour échographe ultrasonore, comportant un filtre du type à lignes à retard, caractérisé en ce que le dispositif comporte un premier filtre (100) composé, d'une part, de M lignes parallèles i (i = 1,...,M) de retard respectif (i-1)T, T étant la période de récurrence de l'échographe, d'autre part, de moyens de pondération (101i) des M lignes i, la somme des coefficients ($a_i$) affectés auxdites lignes étant nulle, et, enfin, d'un additionneur (102) des lignes i ainsi retardées et pondérées, audit premier filtre (100) étant associé en parallèle au moins un deuxième filtre (200) de même structure, conjugué du premier filtre (100) et déphasé de (M-1)T, la réponse impulsionnelle ($h_2(t)$) du deuxième filtre étant reliée à la réponse impulsionnelle ($h_1(t)$) du premier filtre par :

$$h_2(t) = h_1((M-1)T-t)$$

2. Dispositif selon la revendication 1, caractérisé en ce que, M étant égal à 3 et lesdits coefficients $a_1$, $a_2$ et $a_3$ étant respectivement 1, $-\tfrac{1}{2}$, $-\tfrac{1}{2}$, les réponses impulsionnelles des premier et deuxième filtres sont respectivement :

$$h_1(t) = \delta(t) - \tfrac{1}{2}\delta(t\text{-}T) - \tfrac{1}{2}\delta(t\text{-}2T)$$
$$h_2(t) = -\tfrac{1}{2}\delta(t) - \tfrac{1}{2}\delta(t\text{-}T) + \delta(t\text{-}2T)$$

où $\delta(t)$ est la fonction de Dirac.

## Claims

1. A device for eliminating fixed echoes for an ultrasonic echograph, comprising a filter of the type comprising delay lines, characterized in that the device comprises a first filter (100) which consists on the one hand of M parallel lines i (i = 1, ...,M) having a respective delay (i-1)T, where T is the repetition period of the echograph, and on the other hand of weighting means (101i) for weighting the M fines i, the sum of the coefficients ($a_1$) applied to said fines being zero, and of an adder (102) for the lines i thus delayed and weighted, at least one second filter (200) which has the same structure as the first filter (100) and which is dephased by (M-1)T with respect to the first filter (100) being connected parallel to the first filter (100), the pulse response $h_2(t)$ of the second filter being linked to the pulse response $h_1(t)$ of the first filter as:

$$h_2(t) = h_1((M-1)T-t)$$

2. A device as claimed in Claim 1, characterized in that, M being equal to 3 and said coefficients $a_1$, $a_2$ and $a_3$ being 1, -1/2, -1/2, respectively, the pulse responses of the first and the second filter are:

$$h_1(t) = \delta(t) - 1/2\delta(t-T) - 1/2\delta(t-2T)$$
$$h_2(t) = -1/2\delta(t) - 1/2\delta(t-T) + \delta(t-2T)$$

where $\delta(t)$ is the Dirac function.

## Patentansprüche

1. Gerät zum Beseitigen von Festechos für Ultraschallechographie, mit einem Filter mit Verzögerungsleitungen, dadurch gekennzeichnet, daß das Gerät ein erstes Filter (100) enthält, das einerseits aus M parallelen Verzögerungsleitungen i (i = 1...M) mit einer Verzögerung von (i-1)T, worin T die Wiederholungsperiode des Echographen darstellt, andererseits aus Gewichtungsmitteln (101i) der M Leitungen i, wobei die Summe der bei diesen Leitungen benutzten Koeffizienten ($a_i$) gleich Null ist, und schließlich aus einem Addierer (102) der auf diese Weise verzögerten und gewogenen Leitungen i zusammengesetzt ist, wobei mit dem ersten Filter (100) wenigstens in Parallelschaltung ein zweites Filter (200) der gleichen Struktur kombiniert ist, das mit dem ersten Filter (100) verknüpft und über (M-1)T phasenverschoben ist, und die Impulswiedergabe ($h_2$-(t)) des zweiten Filters mit der Impulswiedergabe ($h_1(t)$) des ersten Filters mit folgender Gleichung verbunden ist:

$$h_2(t) = h_1((M-1)T-t)$$

2. Gerät nach Anspruch 1, dadurch gekennzeichnet, daß M gleich 3 ist und die Koeffizienten $a_1$, $a_2$ und $a_3$ 1, -1/2, bzw. -1/2 betragen, und die Impulswiedergaben der ersten und zweiten Filter wie folgt sind:

$$h_1(t) = \delta(t) - \tfrac{1}{2}\delta(t-T) - \tfrac{1}{2}\delta(t-2T)$$
$$h_2(t) = -\tfrac{1}{2}\delta(t) - \tfrac{1}{2}\delta(t-T) + \delta(t-2T)$$

worin $\delta(t)$ die Diracsche Funktion ist.

FIG.1

FIG.2

FIG.3